# FASCICULE DE BREVET EUROPEEN

(11) **EP 2 120 243 B1**
(45) Date de publication et mention de la délivrance du brevet: **14.01.2015**
(21) Numéro de dépôt: 09158214.8
(22) Date de dépôt: 20.04.2009
(51) Int. Cl.: H01H 11/00, G01R 1/067

(54) **Adaptateur pour fiche de test**
Adapter für Prüfstecker
Adapter for test plug

(30) Priorité: 15.05.2008 FR 0802635
(43) Date de publication de la demande: 18.11.2009
(73) Titulaire: ABB France, 91978 Courtaboeuf Cedex (FR)
(72) Inventeur: Bianchi, Fabrice, 69330 Jonage (FR); Moine, Geoffrey, 69130 Ecully (FR)
(74) Mandataire: Verriest, Philippe

(56) Documents cités:
- DE-A1- 3 209 208
- FR-A- 2 195 084
- FR-A- 2 337 342
- US-A- 3 244 801
- US-A1- 2008 076 298

## Description

La présente invention concerne un adaptateur pour fiche de test.

Un tel adaptateur comprend de façon connue un organe électriquement conducteur comportant des moyens de réception d'une fiche de test et des moyens agencés pour entrer en contact électrique avec une barrette conductrice d'un appareil électrique. L'organe électriquement conducteur de l'adaptateur est agencé pour relier électriquement la fiche de test à la barrette conductrice de l'appareil électrique.

Les moyens de réception de ce type d'adaptateur permettent la réception d'un seul type de fiche de test.

En conséquence, pour chaque type de fiche de test, un opérateur doit disposer d'un adaptateur adapté.

Le document US 3 244 801 A décrit un adaptateur pour fiche de test selon le préambule de la revendication 1.

L'adaptateur décrit dans le document US 3 244 801 est monobloc, et comprend plus particulièrement une partie de réception délimitant un logement cylindrique, une partie de raccordement électrique opposée à la partie de réception, et une partie intermédiaire reliant les parties de réception et de raccordement électrique, la partie de réception comprenant deux paires de fentes opposées s'étendant uniquement sur une portion de la hauteur de la partie de réception et du logement cylindrique de telle sorte qu'une portion du logement cylindrique présente un diamètre invariable.

Un tel adaptateur monobloc est compliqué à fabriquer, et présente donc des coûts de fabrication élevés.

En outre, ce type d'adaptateur ne convient qu'aux fiches de tests ayant un diamètre très proche. Il est donc nécessaire de mettre à la disposition d'un opérateur un nombre important d'adaptateurs pour pouvoir utiliser des fiches de test présentant des diamètres différents.

La présente invention vise à remédier à cet inconvénient, et de manière avantageuse elle consiste à fournir un adaptateur qui soit de structure simple et qui permette la réception de plusieurs type de fiches de test, en particulier de diamètres différents.

A cet effet, la présente invention concerne un adaptateur selon la revendication 1.

Cette structure des portions de réception permet l'adaptation de fiches de test de différentes dimensions sur l'adaptateur. De ce fait, il n'est plus nécessaire pour un opérateur de disposer d'un nombre important d'adaptateurs.

Avantageusement, les éléments constituant l'organe électriquement conducteur comportent respectivement des moyens de fixation complémentaires.

Selon un mode de réalisation de l'invention, les moyens de fixation complémentaires sont ménagés sensiblement au centre des éléments constituant l'organe électriquement conducteur.

Selon un autre mode de réalisation de l'invention, les moyens de fixation complémentaires comprennent au moins un ergot de fixation ménagé sur le premier élément et au moins un logement de forme complémentaire ménagé sur le second élément et destiné à recevoir l'ergot ménagé sur le premier élément.

De préférence, l'adaptateur comprend un manchon de protection réalisé en matière isolante et entourant au moins en partie l'organe électriquement conducteur.

Avantageusement, une portion du manchon de protection située autour des portions de réception présente des dimensions intérieures telles qu'un espacement est ménagé entre le manchon et les portions de réception.

Ces dispositions permettent notamment un emmanchement d'une portion tubulaire cylindrique d'une fiche de test autour des portions de réception. Avantageusement, l'adaptateur comprend des moyens d'accrochage de l'organe électriquement conducteur dans le manchon de protection.

Selon un mode de réalisation de l'invention, les moyens d'accrochage comprennent des pointes d'accrochage ménagées sur les éléments constituant l'organe électriquement conducteur et destinées à coopérer avec la surface intérieure du manchon de protection.

Avantageusement, au moins une portion du manchon de protection est conçue pour être disposée sans jeu autour de l'organe électriquement conducteur.

Ces dispositions permettent, en réalisant la portion par exemple par surmoulage, d'obtenir une meilleure élasticité globale de la fiche de test.

Selon encore un autre mode de réalisation de l'invention, chaque portion de réception présente une forme de demi-cylindre.

De toute façon l'invention sera bien comprise à l'aide de la description qui suit en référence au dessin schématique annexé représentant, à titre d'exemple non limitatif, une forme d'exécution de cet adaptateur.
Figure 1 est une vue en perspective d'un adaptateur selon un premier mode de réalisation de l'invention.
Figure 2 est une vue en perspective de l'organe électriquement conducteur de l'adaptateur de figure 1.
Figure 3 est une vue en perspective d'un élément constitutif de l'organe électriquement conducteur de figure 2.
Figure 4 est une vue en coupe longitudinale de l'adaptateur de figure 1.
Figure 5 est une vue en coupe longitudinale de l'adaptateur de figure 1 en position insérée dans un appareil électrique.

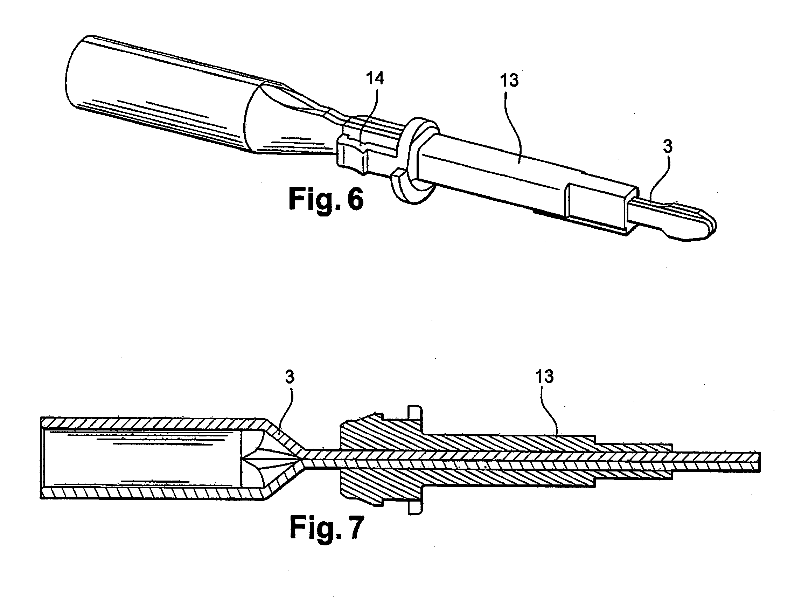

La figure 6 est une vue en perspective d'un second mode de réalisation d'un adaptateur selon l'invention.
La figure 7 est une vue en coupe de l'adaptateur de figure 6.

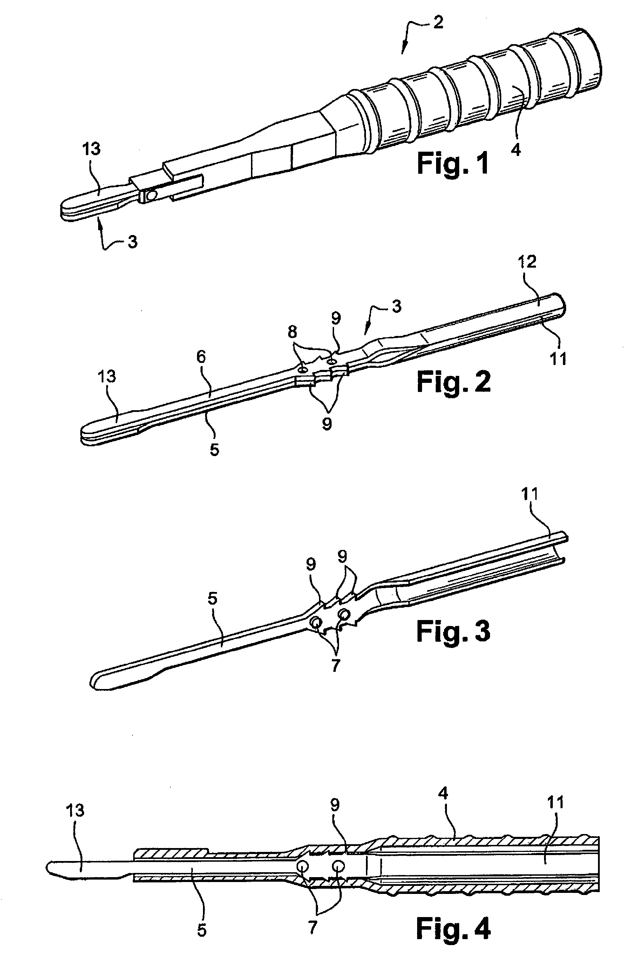

Les figures 1 à 4 représentent un adaptateur 2 pour fiche de test selon un premier mode de réalisation.

L'adaptateur 2 comprend un organe électriquement conducteur 3 et un manchon de protection 4 entourant en partie l'organe électriquement conducteur 3. L'organe électriquement conducteur 3 est métallique tandis que le manchon de protection 4 est réalisé en matière isolante.

L'organe électriquement conducteur 3 est agencé pour relier électriquement une fiche de test à une barrette conductrice d'un appareil électrique.

L'organe électriquement conducteur 3 est constitué par des premier et second éléments 5, 6 distincts l'un de l'autre. Les éléments 5, 6 constituant l'organe électriquement conducteur 3 comportent respectivement des moyens de fixation complémentaires. Ces moyens de fixation complémentaires sont ménagés sensiblement au centre des éléments 5, 6 et comprennent deux ergots de fixation 7 ménagés sur le premier élément 5 et deux logements 8 de forme complémentaire ménagés sur le second élément 6 et destinés à recevoir chacun l'un des ergots 7 ménagés sur le premier élément 5.

Les éléments 5, 6 constituant l'organe électriquement conducteur 3 comprennent des moyens d'accrochage de l'organe électriquement conducteur 3 dans le manchon de protection 4. Ces moyens d'accrochage comprennent des pointes d'accrochage 9 ménagées sur les éléments 5, 6 à proximité des moyens de fixation complémentaires et destinées à coopérer avec la surface intérieure du manchon de protection 4.

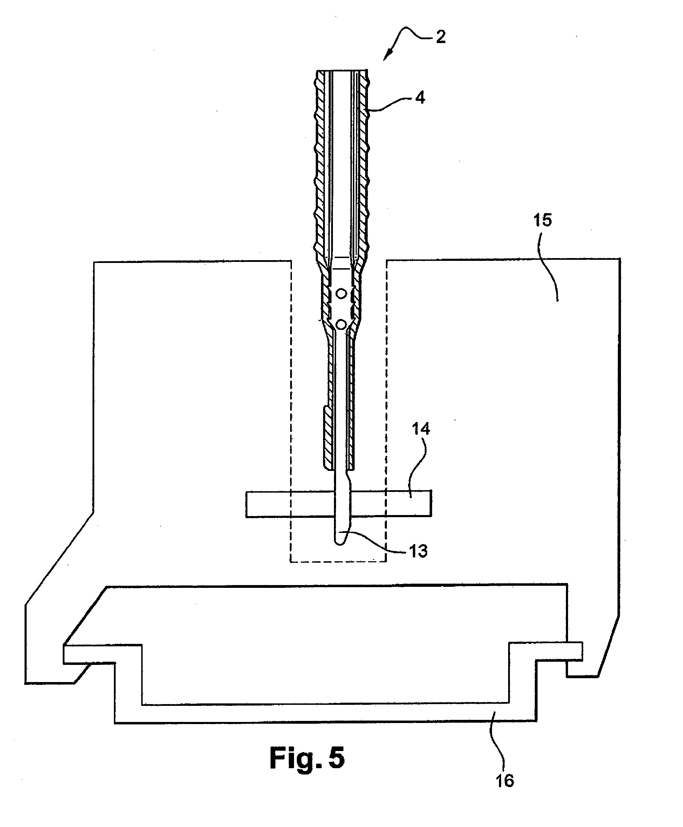

L'organe électriquement conducteur 3 comporte à une première extrémité des moyens de réception 11, 12 d'une fiche de test et à une seconde extrémité des moyens 13 agencés pour entrer en contact électrique avec une barrette conductrice 14 d'un appareil électrique 15 fixé sur un rail de support 16, comme cela est représenté sur la figure 5.

Les moyens de réception comprennent deux portions de réception 11, 12 ménagées respectivement sur les premier et second éléments 5, 6 constituant l'organe électriquement conducteur 3. Les portions de réception 11, 12 présentent chacune une forme de demi-cylindre.

Les portions de réception 11, 12 sont mobiles l'une par rapport à l'autre et sont agencées pour former une zone de réception de fiche de test de dimensions variables. La mobilité des portions de réception 11, 12 est obtenue par déformation élastique des éléments 5, 6 lors de l'insertion d'une fiche de test entre les portions de réception.

Les surfaces intérieures des deux portions de réception 11, 12 délimitent un logement sensiblement cylindrique de diamètre variable tandis que les surfaces extérieures des deux portions de réception délimitent une surface cylindrique.

La portion du manchon de protection 4 située autour des portions de réception 11, 12 présente un diamètre intérieur tel qu'un espacement est ménagé entre le manchon 4 et les portions de réception 11, 12.

Ainsi, les portions de réception 11, 12 permettent soit l'insertion de fiches de test de différents diamètres entre celles-ci, les deux portions de réception s'adaptant aux dimensions extérieures des fiches de test en s'écartant l'une de l'autre, soit un emmanchement d'une portion tubulaire cylindrique d'une fiche de test autour de celles-ci.

Cette structure des portions de réception permet donc l'adaptation de fiches de test de différentes dimensions et de différentes formes sur l'adaptateur.

Selon un second mode de réalisation, le manchon de protection 4 est réalisé en deux parties, dont une première partie 13 réalisée par surmoulage sur l'organe électriquement conducteur 3.

Ces dispositions permettent de supprimer le jeu entre la partie de manchon et l'organe électriquement conducteur et d'obtenir une meilleure élasticité globale de la fiche de test.

La seconde partie du manchon, non représentée sur les figures, est fixée par encliquetage sur la première partie par des moyens de fixation complémentaire de moyens de fixation 14 de la première partie de manchon.

La seconde partie du manchon est réalisée de façon à ce que la portion du manchon de protection 4 située autour des portions de réception 11, 12 présente un diamètre inférieur tel qu'un espacement est ménagé entre le manchon 4 et les portions de réception 11, 12.

Comme il va de soi, l'invention ne se limite pas à la seule forme d'exécution de cet adaptateur, décrite ci-dessus à titre d'exemple, elle en embrasse au contraire toutes les variantes de réalisation.

## Revendications

1. Adaptateur (2) pour fiche de test comprenant un organe électriquement conducteur (3) comportant des moyens de réception (11, 12) d'une fiche de test et des moyens (13) agencés pour entrer en contact électrique avec une barrette conductrice (14) d'un appareil électrique (15), l'organe électriquement conducteur (3) étant agencé pour relier électriquement la fiche de test à la barrette conductrice de l'appareil électrique, les moyens de réception comprenant deux portions de réception (11, 12) mobiles l'une par rapport à l'autre et agencées pour former une zone de réception de fiche de test de dimensions variables, les surfaces intérieures des deux portions de réception (11, 12) délimitant un logement cylindrique de diamètre variable, **caractérisé en ce que** l'organe électriquement conducteur (3) est constitué par des premier et second éléments (5, 6) distincts l'un de l'autre et comprenant chacun l'une des portions de réception (11, 12).

2. Adaptateur selon la revendication 1, dans lequel les éléments (5, 6) constituant l'organe électriquement conducteur (3) comportent respectivement des moyens de fixation complémentaires (7, 8).

3. Adaptateur selon la revendication 2, dans lequel les moyens de fixation complémentaires sont ménagés sensiblement au centre des éléments constituant l'organe électriquement conducteur.

4. Adaptateur selon l'une des revendications 2 et 3, dans lequel les moyens de fixation complémentaires comprennent au moins un ergot de fixation (7) ménagé sur le premier élément (5) et au moins un logement (8) de forme complémentaire ménagé sur le second élément (6) et destiné à recevoir l'ergot ménagé sur le premier élément.

5. Adaptateur selon l'une des revendications 1 à 4, comprenant un manchon de protection (4) réalisé en matière isolante et entourant au moins en partie l'organe électriquement conducteur (3).

6. Adaptateur selon la revendication 5, dans lequel une portion du manchon de protection (4) située autour des portions de réception (11, 12) présente des dimensions intérieures telles qu'un espacement est ménagé entre le manchon (4) et les portions de réception (11, 12).

7. Adaptateur selon l'une des revendications 5 ou 6, comprenant des moyens d'accrochage de l'organe électriquement conducteur dans le manchon de protection.

8. Adaptateur selon la revendication 7, dans lequel les moyens d'accrochage comprennent des pointes d'accrochage (9) ménagées sur les éléments (5, 6) constituant l'organe électriquement conducteur (3) et destinées à coopérer avec la surface intérieure du manchon de protection (4).

9. Adaptateur selon l'une des revendications 5 à 8, dans lequel au moins une portion (13) du manchon de protection est conçue pour être disposée sans jeu autour de l'organe électriquement conducteur (3).

10. Adaptateur selon l'une des revendications précédentes, dans lequel chaque portion de réception (11, 12) présente une forme de demi-cylindre.

## Patentansprüche

1. Adapter (2) für Prüfstecker, der ein elektrisch leitendes Element (3) aufweist, das Mittel (11, 12) zum Aufnehmen eines Prüfsteckers und Mittel (13) aufweist, die eingerichtet sind, um mit einer leitenden Leiste (14) eines Elektrogeräts (15) in elektrischen Kontakt zu treten, wobei das elektrisch leitende Element (3) eingerichtet ist, um den Prüfstecker elektrisch mit der leitenden Leiste des Elektrogeräts zu verbinden, wobei die Aufnahmemittel zwei Aufnahmeabschnitte (11, 12) aufweisen, die zueinander beweglich und eingerichtet sind, um eine Aufnahmezone für Prüfstecker mit variablen Maßen aufzunehmen, wobei die inneren Oberflächen der zwei Aufnahmeabschnitte (11, 12) eine zylindrische Aufnahme mit variablem Durchmesser abgrenzen, **dadurch gekennzeichnet, dass** das elektrisch leitende Element (3) aus ersten und zweiten voneinander getrennten Elementen (5, 6) besteht und jeweils einen der Aufnahmeabschnitte (11, 12) umfasst.

2. Adapter nach Anspruch 1, bei dem die Elemente (5, 6), die das elektrisch leitende Element (3) bilden, jeweils komplementäre Befestigungsmittel (7, 8) aufweisen.

3. Adapter nach Anspruch 2, bei dem die komplementären Befestigungsmittel im Wesentlichen in der Mitte der Elemente, die das elektrisch leitende Element bilden, eingerichtet sind.

4. Adapter nach einem der Ansprüche 2 und 3, bei dem die komplementären Befestigungsmittel mindestens einen Befestigungsdorn (7) aufweisen, der auf dem ersten Element (5) eingerichtet ist, und mindestens eine Aufnahme (8) mit komplementärer Form, die auf dem zweiten Element (6) eingerichtet und dazu bestimmt ist, den Dorn, der auf dem ersten Element eingerichtet ist, aufzunehmen.

5. Adapter nach einem der Ansprüche 1 bis 4, der eine Schutzhülse (4) aufweist, die aus isolierendem Material hergestellt ist und das elektrisch leitende Element (3) mindestens teilweise umgibt.

6. Adapter nach Anspruch 5, bei dem ein Abschnitt der Schutzhülse (4), der um Aufnahmeabschnitte (11, 12) liegt, Innenmaße derart aufweist, dass zwischen der Hülse (4) und den Aufnahmeabschnitten (11, 12) ein Abstand eingerichtet ist.

7. Adapter nach einem der Ansprüche 5 oder 6, der Mittel zum Anhängen des elektrisch leitenden Elements in der Schutzhülse aufweist.

8. Adapter nach Anspruch 7, bei dem die Anhängmittel Anhängspitzen (9) aufweisen, die auf den Elementen (5, 6), die das elektrisch leitende Element (3) bilden und dazu bestimmt sind, mit der inneren Oberfläche der Schutzhülse (4) zusammenzuwirken, eingerichtet sind.

9. Adapter nach einem der Ansprüche 5 bis 8, bei dem mindestens ein Abschnitt (13) der Schutzhülse ausgelegt ist, um ohne Spiel um das elektrisch leitende Element (3) angeordnet zu sein.

10. Adapter nach einem der vorhergehenden Ansprüche, bei dem jeder Aufnahmeabschnitt (11, 12) eine halb zylindrische Form aufweist.

## Claims

1. An adapter (2) for test plug comprising an electrically conductive member (3) including receiving means (11, 12) of a test plug and means (13) arranged to come into electrical contact with a conductive bar (14) of an electrical apparatus (15), the electrically conductive member (3) being arranged to electrically connect the test plug to the conductive bar of the electrical apparatus, the receiving means comprising two receiving portions (11, 12) movable with respect to one another and arranged to form a test plug receiving area of varying dimensions, the inner surfaces of the two receiving portions (11, 12) delimiting a cylindrical housing of varying diameter, **characterized in that** the electrically conductive member (3) is constituted by first and second elements (5, 6) separate from one another and each comprising one of the receiving portions (11, 12).

2. The adapter according to claim 1, wherein the elements (5, 6) constituting the electrically conductive member (3) respectively include complementary fastening means (7, 8).

3. The adapter according to claim 2, wherein the complementary fastening means are arranged substantially at the center of the elements constituting the electrically conductive member.

4. The adapter according to any of claims 2 and 3, wherein the complementary fastening means comprise at least one fastening lug (7) arranged on the first element (5) and at least one housing (8) of complementary shape arranged on the second element (6) and intended to receive the lug arranged on the first element.

5. The adapter according to any of claims 1 to 4, comprising a protection sleeve (4) made of insulating material and surrounding at least part of the electrically conductive member (3).

6. The adapter according to claim 5, wherein a portion of the protection sleeve (4) located around the receiving portions (11, 12) has inner dimensions such that a spacing is arranged between the sleeve (4) and the receiving portions (11, 12).

7. The adapter according to any of claims 5 or 6, comprising attachment means of the electrically conductive member in the protection sleeve.

8. The adapter according to claim 7, wherein the attachment means comprise attachment tips (9) provided on the elements (5, 6) constituting the electrically conductive member (3) and intended to cooperate with the inner surface the protection sleeve (4).

9. The adapter according to any of claims 5 to 8, wherein at least one portion (13) of the protection sleeve is designed to be disposed without clearance around the electrically conductive member (3).

10. The adapter according to any of the preceding claims, wherein each receiving portion (11, 12) has a shape of a half cylinder.
